# EUROPÄISCHE PATENTSCHRIFT

(11) **EP 2 063 521 B1**
(45) Veröffentlichungstag und Bekanntmachung des Hinweises auf die Patenterteilung: **09.11.2011**
(21) Anmeldenummer: 07121122.1
(22) Anmeldetag: 20.11.2007
(51) Int. Cl.: H02M 3/158, G05F 1/59, H03K 17/12

(54) **Vorrichtung zum Treiben einer Last**
Device for driving a load
Dispositif d'entraînement d'une charge

(43) Veröffentlichungstag der Anmeldung: 27.05.2009
(73) Patentinhaber: ELMOS Semiconductor AG, 44227 Dortmund (DE)
(72) Erfinder: Fischer, Barbara, 58636 Iserlohn (DE); Abaza, Fikret, 47169 Duisburg (DE); Feucht, Christian, 44359 Dortmund (DE)
(74) Vertreter: von Kreisler Selting Werner

(56) Entgegenhaltungen:
- DE-A1- 10 322 118
- DE-A1- 19 821 195
- JP-A- 11 235 015
- JP-A- 61 220 012
- US-A- 4 149 233
- US-A- 5 157 269

## Beschreibung

Die Erfindung betrifft eine Vorrichtung zum Treiben einer Last, bei der es sich insbesondere um ein Kfz-Gebläsemotor handelt.

Bei einer Vielzahl von Anwendungsfällen ist es üblich, den Strom durch einen elektrischen Verbraucher (Last) mit Hilfe eines Halbleiterschalters (beispielsweise eines MOS-Transistors) zu steuern. Dabei entsteht in dem Schalter elektrische Verlustleistung, die in Form von Wärme abgeführt wird. Transistoren, die hohen Verlustleistungen standhalten müssen, sind kostenintensiver als Transistoren, die für kleinere, maximal zulässige Verlustleistungen ausgelegt sind. Auch steigt mit zunehmender Verlustleistung der Aufwand, der beispielsweise für die Kühlung des Transistors betrieben werden muss.

Daher geht man mitunter dazu über, einen elektrischen Verbraucher durch zwei oder mehr parallel geschaltete Transistoren anzusteuern. Dies hat den Vorteil, dass jeder einzelne Transistor für eine geringere maximal zu erwartende Verlustleistung ausgelegt sein muss. Voraussetzung hierfür ist allerdings, dass darauf geachtet wird, dass durch die parallel geschalteten Transistoren im wesentlichen die gleichen Treiberströme fließen (Symmetrierung). Die Parallelschaltung mehrerer Transistoren hat darüber hinaus den Vorteil, dass bei Ausfall eines Transistors die Last immer noch betrieben werden kann (gegebenenfalls in verringertem Maße).

Zur im wesentlichen symmetrischen Aufteilung des Treiberstroms einer Last durch zwei parallel geschaltete. Transistoren ist es bekannt, die Teilströme durch beide Transistoren jeweils zu regeln, wobei der eine Regelkreis dem anderen Regelkreis folgt (Master-Slave-Anordnung). Derartige Systeme sind beispielsweise in EP-A-1 422 819, EP-A-0 354 098, US-A-3 675 114 und DE-A-35 38 584 beschrieben.

Eine Schaltungsanordnung einer Vorrichtung zum Treiben einer Last gemäß dem Oberbegriff des Anspruchs 1, die zwei Transistoren aufweist, denen jeweils mit ein und demselben Sollwert versorgte Stromregeleinrichtungen zugeordnet sind, ist aus JP-A-11235015 bekannt.

Aufgabe der Erfindung ist es, eine Vorrichtung zum Treiben einer Last zu schaffen, bei der auf regelungstechnisch einfache Art und Weise der Treiberstrom symmetrisch auf mehrere parallel geschaltete Zweige mit Halbleiter-Schaltern aufgeteilt wird und Vorkehrungsmaßnahmen zur Verhinderung einer Zerstörung infolge eines in einem der Zweige fließenden, zu hohen Stroms getroffen sind.

Zur Lösung dieser Aufgabe wird mit der Erfindung eine Vorrichtung zum Treiben einer Last, insbesondere eines Kfz-Gebläsemotors, vorgeschlagen, die versehen ist mit den Merkmalen des Anspruchs 1 Einzelme Ausgestaltungen der Erfindung sind Gegenstand der Unteransprüche.

Die erfindungsgemäße Vorrichtung weist mindestens zwei Stromsteuerelemente auf, deren Ströme zusammen zum Treiben der Last dienen. Die Steuerelemente (nachfolgend der Einfachheit halber Transistoren genannt) werden von ihnen jeweils zugeordneten getrennten Stromregeleinrichtungen geregelt. Wenn die Vorrichtung also einen ersten und einen zweiten Transistor aufweist, so ist dem ersten Transistor die erste Stromregeleinrichtung und dem zweiten Transistor die zweite Stromregeleinrichtung zugeordnet. Beide Stromregeleinrichtungen erhalten bei normalem Betrieb der Vorrichtung einen gemeinsamen Sollwert für den zu regelnden Strom durch die Transistoren, wobei der Sollwert von einem Sollwertgeber vorgegeben wird. In dem Normalbetriebsmodus (erster Betriebsmodus) steuern also die beiden Stromregeleinrichtungen die ihnen zugeordneten Transistoren auf der Grundlage eines gemeinsamen Sollwerts an. Dieser erste Betriebsmodus bleibt solange aufrechterhalten, wie sich die Istwerte der durch die beiden Transistoren fließenden Ströme um weniger als einen vorgebbaren Schwellwert voneinander unterscheiden, also im wesentlichen gleich groß sind (symmetrische Laststromaufteilung).

Kommt es nun beispielsweise zu einer Störung dergestalt, dass der Strom durch den einen Transistor um mehr als den Schwellwert größer ist als der Strom durch den anderen Transistor, so wird durch eine Steuereinheit von dem ersten Betriebsmodus auf einen zweiten Betriebsmodus umgeschaltet. In diesem zweiten Betriebsmodus wird als Sollwert für die Stromregelung des Transistors, durch den zuvor der kleinere der beiden Ströme geflossen ist, der Istwert des größeren Transistorstroms gewählt. Zusätzlich wird der Transistor mit dem größeren Transistorstrom nicht mehr von der ihm zugeordneten Stromregeleinrichtung angesteuert. In diesem Betriebsmodus wird also der Transistor mit dem kleineren Transistorstrom wieder soweit aufgesteuert, bis durch beide Transistoren der gleiche Strom fließt. Durch dieses Verfahren wird also ein Überstromschutz für den Zweig mit dem größeren Strom realisiert (die Tatsache, dass der Strom in einem der parallel geschalteten Transistoren den Strom durch den anderen Transistor bzw. den kleinsten der durch die anderen Transistoren fließenden Strom um einen vorgegebenen Wert überschreitet, ist z.B. auf einen Kurzschluss des betreffenden Transistors zurückzuführen). Aus dem zweiten Betriebsmedus (Überstom-Schutzmodus) wird beispielsweise dann wieder auf den Normalbetriebsmodus zurückgeschaltet, wenn der Spannungsabfall über der Last (alternativ der Strom durch die Last) wieder unterhalb des Sollwerts eines der Vorrichtung übergeordneten Systems liegt.

In vorteilhafter Weiterbildung der Erfindung ist vorgesehen, dass in dem ersten Betriebsmodus dem Sollwertgeber ein Vorgabewert zur Regelung der Spannung über der Last oder des Stroms durch die Last auf den Vorgabewert zuführbar ist. Die erfindungsgemäße Vorrichtung ist somit als untergelagerter Regler für den die Last treibenden Strom zu verstehen.

Zur Verbesserung des Schutzes der erfindungsgemäßen Vorrichtung gegen eine Zerstörung auf Grund einer sich abzeichnenden Überschreitung der zulässigen Verlustleistungen der Transistoren ist in Weiterbildung der Erfindung vorgesehen, dass dem Sollwertgeber in einem dritten Betriebsmodus zur Begrenzung des Laststroms auf einen Maximalwert ein Vorgabewert zuführbar ist, wenn die Summe der durch die Transistoren fließenden Ströme einen vorgebbaren Schwellwert überschreitet. Diese Begrenzung der Stromregelung auf einen maximal zulässigen Wert verhindert eine (thermische) Zerstörung der Transistoren wegen Überschreitung ihrer maximal zulässigen Verlustleistung. Wie bereits oben erwähnt, ist die Anzahl der parallel geschalteten Stromsteuerelement der erfindungsgemäßen Vorrichtung nicht auf zwei beschränkt sondern beliebig erweiterbar. Bei mehr als zwei Stromsteuerelementen gibt die Steuereinheit im zweiten Betriebsmodus der Vorrichtung den Istwert des größten durch einen der Stromsteuerelemente fließenden Stroms (Überstrom) als Sollwert für die Stromregeleinrichtungen der anderen Transistoren vor. Damit steuern diese anderen Transistoren soweit auf, bis durch sämtliche Transistoren der gleiche Strom fließt, so dass durch den Transistor mit Überstrom ein reduzierter Strom fließt.

Die erfindungsgemäBe Vorrichtung hat den Vorteil, dass die Stromregeleinrichtungen die Istströme durch die ihnen zugeordneten Stromsteuerelemente unabhängig voneinander regeln, und zwar auf den gleichen Sollwert. Sämtliche Stromregeleinrichtungen und diesbezüglichen Regelkreise sind also parallel zueinander geschaltet, wobei diese Parallelschaltung aus Stromregelkreisen wiederum einem übergeordneten Regelsystem für die Last unterlagert ist. Das erfindungsgemäße Konzept ist problemlos erweiterbar auf eine beliebige Anzahl von Stromsteuerelementen und lässt sich sowohl analog als auch digital realisieren. Die voneinander getrennt erfolgende Regelung der Einzeltransistorströme ist insbesondere im Falle eines Fehlers in einem der Transistoren von Vorteil. Darüber hinaus umfasst die erfindungsgemäße Vorrichtung Szenarien für eine Strombegrenzung, eine Leistungsbegrenzung und einen Überstromschutz, wie es oben im einzelnen beschrieben ist.

Die Erfindung wird nachfolgend anhand eines Ausführungsbeispiels unter Bezugnahme auf die Zeichnung näher erläutert. Im einzelnen zeigen dabei:
- Fig. 1: ein Ausführungsbeispiel einer Schaltung zum Treiben einer Last mit symmetrischer Verteilung des Laststroms auf in diesem Ausführungs- beispiel zwei Transistoren, wobei in Fig. 1 die Verschaltung im Normalbetrieb (erster Betriebsmodus) gezeigt ist,

- Fig. 2: die Schaltung gemäß Fig. 1 im zweiten Betriebsmodus (Überstrom- schutz für in diesem Ausführungsbeispiel den rechts in der Schaltung gezeigten Treibertransistor) und
- Fig. 3: die Verschaltung in einem dritten Betriebsmodus (Leistungsbegren- zung).

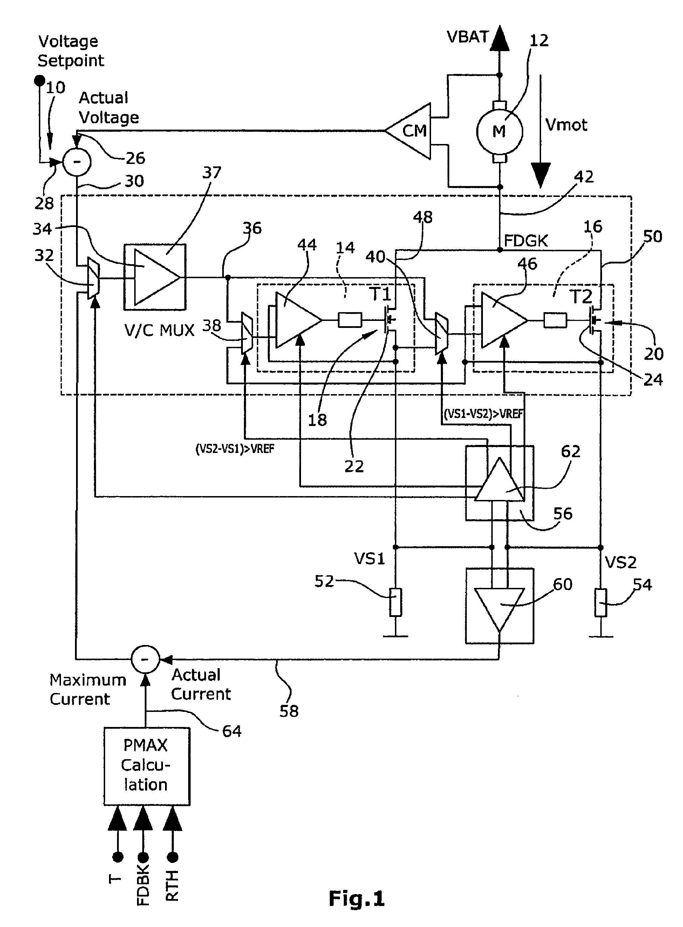

In Fig. 1 ist eine Schaltung 10 eines Regelkreises zur Spannungsregelung an einem Motor 12 mit zwei unterlagerten Stromregelkreien 14,16 zur symmetrischen Aufteilung des Motorstroms auf zwei Stromsteuerelemente 18,20 in From von Transistoren 22,24 gezeigt. Der überlagerte Regelkreis umfasst das rückgeführte Ist-Signal 26 am Motor 12 (beispielsweise Spannungsabfall über dem Motor 12), das mit einem Sollwert 28 verglichen wird. Das Differenzsignal 30 wird über einen entsprechend angesteuerten Multiplexer (Umschalter) 32 und einen Spannungsregelverstärker 34 in einen (Strom-)Sollwert 36 umgesetzt, der als Sollwert für die beiden unterlagerten Stromregelkreise 14,16 dient. Der Spannungsregelverstärker 34 bildet zusammen mit einer Strombegrenzereinheit den Sollwertgeber 37. Der Sollwert 36 wird den beiden Multiplexern 38,40 zugeführt, die im Normalbetriebsmodus so, wie in Fig. 1 gezeigt, geschaltet sind. Der Sollwert 36 für den bei 42 fließenden Laststrom wird einer ersten und einer zweiten Stromregeleinrichtung 44,46 (Verstärker) des ersten und des zweiten Stromregelkreises 14,16 zugeführt. Die Ausgänge der Stromregeleinrichtung 44,46 sind jeweils mit den Steuereingängen der beiden Transistoren 22,24 verbunden. Der bei 48 fließende Strom durch den ersten Transistor 22 wird zum Eingang der Stromregeleinrichtung 44 rückgeführt, während der bei 50 fließende Strom durch den zweiten Transistor 24 zum Eingang der zweiten Stromregeleinrichtung 46 zurückgeführt wird. Über zwei in Reihe mit jeweils einem der Transistoren 22,24 liegenden Shunt-Widerstände 52,54 können die Istwerte der durch die betreffenden Transistoren fließenden Ströme messtechnisch ermittelt werden. Die Messsignale werden einer Steuereinheit 56, die in Abhängigkeit von der Größe der Einzelströme und ihrer Differenz (mit Vorzeichen) die Multiplexer 32,38 und 40 und die Stromregeleinrichtungen 44,46 steuert, und einer Strommesseinrichtung 60 zugeführt, die ein Stromsignal 58 erzeugt.

Wie anhand von Fig. 1 zu erkennen ist und sich aus der vorstehenden Beschreibung ergibt, wird also beiden unterlagerten Stromregelkreisen 14,16 ein Stromsollwert für den durch die zugehörigen Transistoren 22,24 fließenden Strom zugeführt, wobei sich der Stromsollwert aus dem Spannungssollwert für den übergeordneten Regelkreis zur Spannungsregelung des Motors 12 ableitet. Diese Umsetzung ist für die Erfindung nicht zwingend erforderlich. Entscheidend ist vielmehr, dass ein übergeordnetes System die Führungsgröße für zwei bzw. mehrere parallel geschaltete unterlagerte Stromregelkreise liefert, wobei sämtliche unterlagerten Regelkreise unabhängig voneinander arbeiten. Bei dem System kann es sich, wie in diesem Ausführungsbeispiel, um eine Spannungsregelung oder um eine Drehzahlregelung oder ein anders geartetes System handeln.

In Fig. 1 sind die Multiplexer 32, 38 und 40 in demjenigen Zustand dargestellt, den sie einnehmen, wenn sich die Schaltung 10 in ihrem Normalbetriebsmodus befindet. In diesem Betriebsmodus arbeiten die beiden Stromregeleinrichtungen 44,46 normal, sind also aktiviert. Die zueinander parallel fließenden Ströme durch die Transistoren 22,24 sind im wesentlichen gleich groß, was bedeutet, dass sie um weniger als einen vorgebbaren Schwellwert voneinander verschieden sind.

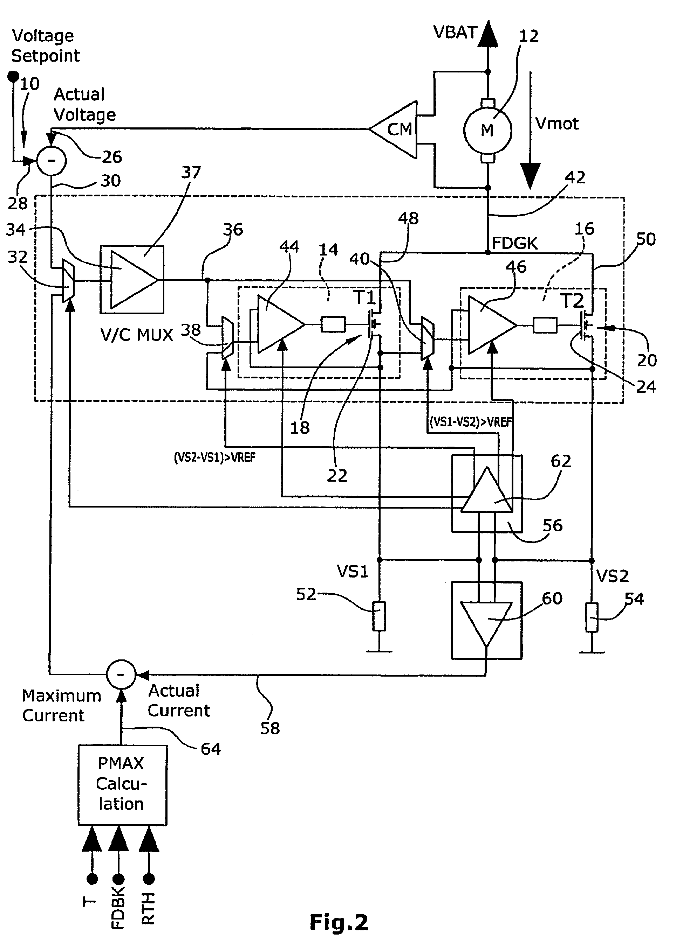

Anhand von Fig. 2 soll nun eine zweite Betriebsart beschrieben werden, die dem Überstromschutz der Transistoren 22,24 und der Zweige, in denen sie angeordnet sind, dient. Dem in Fig. 2 wiedergegebenen Beschaltungszustand der Schaltung 10 vorausgegangen ist, dass in der Steuereinheit 56 erkannt wurde, dass der bei 50 fließende Strom durch den zweiten Transistor 24 ansteigt und insbesondere größer ist als der Strom durch den ersten Transistor 22 zuzüglich des Schwellwerts. Nachfolgend sei dieser Strom durch den Transistor 24 als Kurzschlussstrom bezeichnet. Das Fließen des Kurzschlussstromes führt zwangsläufig zur Zerstörung des Transistors 24, was verhindert werden muss. Hierzu umfasst die Steuereinheit 56 einen Komparator 62, der die die Ströme durch die Transistoren 22,24 repräsentierenden Werte miteinander vergleicht. Ergebnis dieses Vergleichs ist, dass zum Schutz des zweiten Transistors 24 die diesem zugeordnete Stromregeleinrichtung 46 deaktiviert oder wirkungslos geschaltet wird, der Steuereingang des zweiten Transistors 24 also nicht mehr angesteuert wird. Dennoch kann nicht verhindert werden, dass der zweite Transistor 24 weiterhin von dem Kurzschlussstrom durchflossen wird.

Daher wird nun die Stromregelung des ersten Stromregelkreises 14 insofern umgeschaltet, als der Istwert des Stroms durch den zweiten Transistor 24 (Kurzschlussstrom) als Sollwert für den ersten Stromregelkreis 14 verwendet wird. Hierzu wird der Multiplexer 38 von der Steuereinheit 56 angesteuert, so dass nun der Istwert des Stroms durch den zweiten Transistor 24 (Kurzschlussstrom) auf den Sollwerteingang der Stromregeleinrichtung 44 geschaltet wird. Als Folge davon wird der erste Transistor 22 aufgesteuert und "übernimmt" damit in zunehmendem Maße einen Teil des durch den Transistor 24 fließenden Stromes, der somit abnimmt. Auf diese Weise kann der Transistor 24 und der ihm zugeordnete Schaltungszweig vor Zerstörung infolge eines überhöhten Stroms geschützt werden. Der Zustand des Multiplexers 40 des zweiten Stromregelkreises 16 bleibt unverändert, was sich auf den zweiten Stromregelkreis 16 aber nicht auswirkt, da er infolge der Ansteuerung durch die Steuereinheit 56 deaktiviert ist.

Die Rückführung aus dem Überstromschutzbetrieb in den Normalbetrieb kann beispielsweise dann erfolgen, wenn die Spannung über dem Motor 12 wieder kleiner als das Sollwertsignal ist. Im Falle großer fließender Lastströme, was ja auf einen Kurzschluss in einem der Transistoren schließen lässt, steigt nämlich der Spannungsabfall über dem Motor 12 auf einen Wert an, der größer ist als der Sollwert des überlagerten Regelkreises. Wenn diese Anormalität wieder zurückgeführt ist, ist also der Kurzschlussfall beendet, so dass wieder auf den Normalbetriebsmodus gemäß Fig. 1 umgeschaltet werden kann.

Der Überstromschutz für den ersten Transistor 22 erfolgt analog der vorherigen Beschreibung, weshalb auf eine detaillierter Darstellung dieses Szenarios hier nicht weiter eingegangen wird.

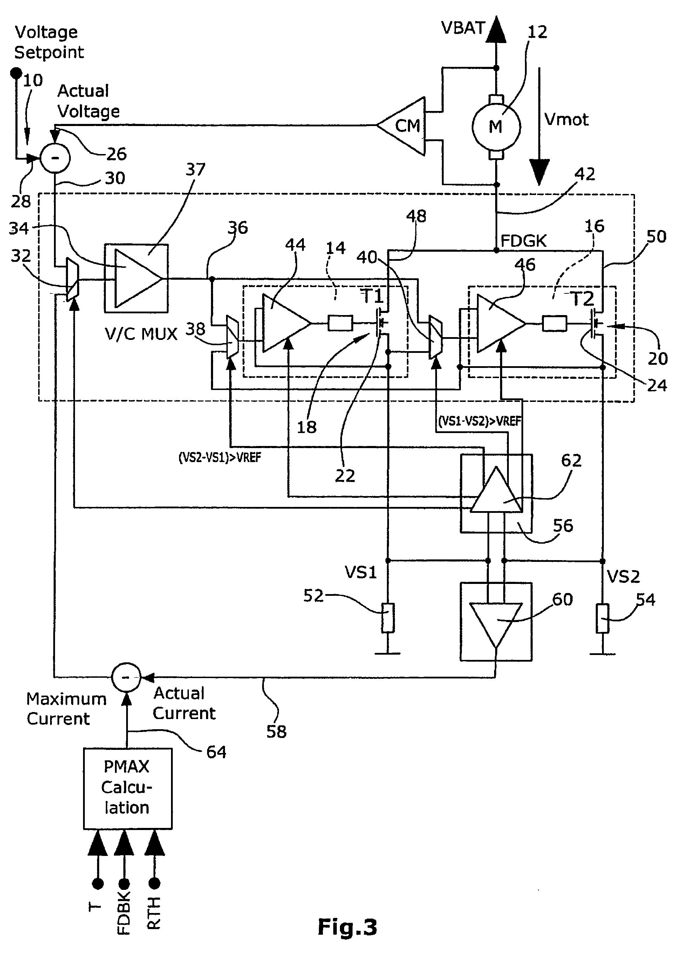

In der Steuereinheit 56 wird mit Hilfe eines Strommessverstärkers 60 der Summenstrom aus den beiden durch die Transistoren 22 und 24 fließenden Teilströme erfasst. Dieser Summenstrom (siehe Signal 58) wird mit einem maximat zulässigen Strom (siehe Signal 64) verglichen. Das Überschreiten des maximal zulässigen Stroms führt dazu, dass die Schattung 10 von der Spannungsregelung, wie sie in den Fign. 1 und 2 gezeigt ist, in die Strombegrenzung übergeht (siehe Fig. 3). In diesem dritten Betriebsmodus ist das Ausgangssignal des Sollwertgebers 37 begrenzt, so dass ein weiteres Ansteigen der Sollwerte für die beiden unterlagerten Stromregelkreise 14,16 verhindert wird. Auf diese Weise werden die Transistoren 22,24 vor Überströmen geschützt. In der dritten Betriebsart ist der Multiplexer 32 durch die Steuereinheit 56 angesteuert, wie es in Fig. 3 gezeigt ist, so dass von der Spannungsregelung des übergeordneten Regelkreises auf die Stromregelung umgeschaltet wird.

Die Größe des maximal zulässigen Stroms (siehe Signal 64) hängt von verschiedenen Faktoren ab. Eine in diesem Zusammenhang besonders wichtige Grenzgröße sind die maximal zulässigen Verlustleistungen in den Transistoren 22 und 24. Diese wiederum lassen sich anhand der Temperaturen T der Transistoren 22,24, ihrer Wärmewiderstände RTH und der Spannungen FDBK über den Transistoren 22,24 ermitteln. Die maximal zulässige Verlustleistung hängt also unter anderem auch von der Güte der Kühlung der Transistoren 22,24 ab. Aus all diesen Größen lässt sich dann der maximal zulässige Strom (siehe Signal 64) ermitteln.

## Patentansprüche

1. Vorrichtung zum Treiben einer Last, insbesondere eines Kraftfahrzeug-Gebläsemotors, mit
- einem ersten und einem zweiten Stromsteuerelement (18,20), die einen zum Treiben der Last vorgesehenen Strom steuern,
- einer dem ersten Stromsteuerelement (18) zugeordneten ersten Stromregeleinrichtung (44) zur Regelung des Istwerts des Stroms durch das erste Stromsteuerelement (18) entsprechend einem Stromsollwert,
- einer dem zweiten Stromsteuerelement (20) zugeordneten zweiten Stromregeleinrichtung (46) zur Regelung des Istwerts des Stroms durch das zweite Stromsteuerelement (20) entsprechend einem Stromsollwert,
- einem Sollwertgeber (37) zur Vorgabe eines Stromsollwerts und
- einer Steuereinheit (56) zur Ansteuerung der ersten und der zweiten Stromregeleinrichtung (44,46),
**dadurch gekennzeichnet,**
- **dass** die Istwerte der durch die Stromsteuerelemente (18,20) fließenden Ströme durch den Stromsteuerelementen (18,20) jeweils zugeordnete erste und zweite Stromsensoren (52,54) erfassbar sind,
- **dass** die Steuereinheit (56) in einem ersten (Normal-)Betriebsmodus, in dem sich die Istwerte der Ströme durch das erste und das zweite Stromsteuerelement (18,20) um weniger als einen vorgebbaren Schwellwert (VREF) unterscheiden, sowohl die erste als auch die zweite Stromregeleinrichtung (44,46) mit dem durch den Sollwertgeber (37) vorgegebenen Sollwert ansteuert, und
- **dass** die Steuereinheit (56) in einem zweiten Betriebsmodus, in dem der Istwert des Stroms durch das erste Stromsteuerelement (18) - oder alternativ durch das zweite Stromsteuerelement (20) - um mindestens den vorgebbaren Schwellwert größer ist als der Istwert des Stroms durch das zweite Stromsteuerelement (20) - oder alternativ das erste Stromsteuerelement (18) -, die erste Stromregeleinrichtung (44) zur Erzeugung eines das erste Stromsteuerelement (18) nicht mehr ansteuernden Ausgangssignals - oder alternativ die zweite Stromregeleinrichtung (46) zur Erzeugung eines das zweite Stromsteuerelement (20) nicht mehr ansteuernden Ausgangssignals - ansteuert und der zweiten Stromregeleinrichtung (46) als Sollwert den Istwert des Stroms durch das erste Stromsteuerelement (18) - oder alternativ der ersten Stromregeleinrichtung (44) als Sollwert den Istwert des Stroms durch das zweite Stromsteuerelement (20) - zuführt.

2. Vorrichtung nach Anspruch 1, **dadurch gekennzeichnet, dass** in dem ersten Betriebsmodus dem Sollwertgeber (37) von einem übergeordneten System ein Vorgabewert zur Regelung der Spannung über der Last oder des Stroms durch die Last auf den Vorgabewert zuführbar ist.

3. Vorrichtung nach Anspruch 1 oder 2, **dadurch gekennzeichnet, dass** in einem dritten Betriebsmodus dem Sollwertgeber (37) ein Vorgabewert zur Begrenzung des der Last zuführbaren Stroms auf einen Maximalwert zuführbar ist, wenn die Summe der durch die Stromsteuerelemente (18,20) fließenden Ströme einen vorgebbaren Schwellwert überschreitet.

4. Vorrichtung nach einem der Ansprüche 1 bis 3, **dadurch gekennzeichnet, dass** die Steuereinheit (56) in dem zweiten Betriebsmodus den Istwert des größten durch eines der Stromsteuerelemente (18,20) fließenden Stroms als Sollwert für die Stromregeleinrichtung (44,46) derjenigen anderen Stromsteuerelemente (18,20) vorgibt.

5. Vorrichtung nach einem der Ansprüche 2 bis 4, **dadurch gekennzeichnet, dass** die Steuereinheit (56) von dem zweiten Betriebsmodus auf den ersten Betriebsmodus umschaltet, wenn die Spannung über der Last oder der Strom durch die Last wieder kleiner als der Vorgabewert des übergeordneten Systems ist.

## Claims

1. A device for driving a load, in particular a vehicle blower motor, comprising
- a first and a second current control element (18, 20) controlling a current intended for driving the load,
- a first current control means (44) assigned to the first current control element (18) for controlling the actual value of the current through the first current control element (18) according to a set current value,
- a second current control means (46) assigned to the second current control element (20) for controlling the actual value of the current through the second current control element (20) according to a set current value,
- a set current transducer (37) for defining a set current value, and
- a control unit (56) for driving the first and the second current control means (44, 46),
**characterized in**
- **that** the actual values of the currents flowing through the current control elements (18, 20) are detectable by a first and a second current sensor (52, 54), respectively assigned to the current control elements (18, 20),
- **that**, in a first (normal) mode, in which the actual values of the currents through the first and the second current control element (18, 20) differ by less than a pre-definable threshold value (VREF), the control unit (56) drives both the first and the second current control unit (44, 46) with the set value defined by the set current transducer (37), and
- **that**, in a second mode, in which the actual value of the current through the first current control element (18) - or alternatively through the second current control element (20) - exceeds the actual value of the current through the second current control element (20) - or alternatively the first current control element (18) - by at least the pre-definable threshold value, the control unit (56) drives the first current control means (44) to generate an output signal no longer driving the first current control element (18) - or alternatively drives the second current control means (46) to generate an output signal no longer controlling the second current control element (20) - and supplies to the second current control means (46) as the set value the actual value of the current through the first current control element (18) - or alternatively supplies to the first current control means (44) as the set value the actual value of the current through the second current control element (20).

2. The device of claim 1, **characterized in that**, in the first mode, a superordinate system can supply the set current transducer (37) with a preset value for controlling the voltage across the load or the current through the load to the preset value.

3. The device of claim 1 or 2, **characterized in that**, in a third mode, the set current transducer (37) can be supplied with a preset value for limiting the current that can be supplied to the load to a maximum, if the sum of the currents flowing through the current control elements (18, 20) exceeds a pre-definable threshold value.

4. The device of one of claims 1 to 3, **characterized in that,** in the second mode, the control unit (56) predefines the actual value of the largest current flowing through one of the current control elements (18, 20) as the set value for the current control means (44, 46) of the other current control element (18, 20).

5. The device of one of claims 2 to 4, **characterized in that** the control unit (56) switches from the second to the first mode, if the voltage across the load or the current through the load is again less than the preset value from the superordinate system.

## Revendications

1. Dispositif pour commander une charge, notamment le moteur du ventilateur d'un véhicule, comprenant
- un premier et un deuxième élément de contrôle de courant (18, 20) contrôlant un courant destiné à commander ladite charge,
- un premier moyen de régulation de courant (44), assigné au premier élément de contrôle de courant (18), pour la régulation de la valeur actuelle du courant à travers ledit premier élément de contrôle de courant (18) en fonction d'une valeur de consigne du courant,
- un deuxième moyen de régulation de courant (46), assigné au deuxième élément de contrôle de courant (20), pour la régulation de la valeur actuelle du courant à travers ledit deuxième élément de contrôle de courant (20) en fonction d'une valeur de consigne du courant,
- un ajusteur de consigne (37) pour prédéfinir une valeur de consigne du courant, et
- une unité de commande (56) pour commander ledit premier et ledit deuxième moyen de régulation de courant (44, 46),
**caractérisé en ce**
- **que** les valeurs actuelles des courants s'écoulant à travers les éléments de contrôle de courant (18, 20) sont détectables par des premier et deuxième capteurs de courant (52, 54) respectivement assignés aux éléments de contrôle de courant (18, 20),
- **que**, dans un premier mode opératoire (normal), dans lequel les valeurs actuelles des courants à travers le premier et le deuxième élément de contrôle de courant (18, 20) diffèrent de moins d'une valeur de seuil (VREF) prédéfinissable, ladite unité de commande (56) commande le premier et le deuxième moyen de régulation de courant (44, 46) avec ladite valeur de consigne prédéfinie par ledit ajusteur de consigne (37), et
- **que**, dans un deuxième mode opératoire, dans lequel la valeur actuelle du courant à travers ledit premier élément de contrôle de courant (18) - ou, alternativement, à travers ledit deuxième élément de contrôle de courant (20) - dépasse la valeur actuelle du courant à travers ledit deuxième élément de contrôle de courant (20) - ou, alternativement, à travers ledit premier élément de contrôle de courant (18) - par au moins ladite valeur de seuil prédéfinissable, ladite unité de commande (56) commande ledit premier moyen de régulation de courant (44) pour générer un signal de sortie ne plus commandant ledit premier élément de contrôle de courant (18) - ou, alternativement, ledit deuxième moyen de régulation de courant (46) pour générer un signal de sortie ne plus commandant ledit deuxième élément de contrôle de courant (20) - et fournit au deuxième moyen de régulation de courant (46) comme valeur de consigne la valeur actuelle du courant à travers ledit premier élément de contrôle de courant (18) - ou, alternativement, fournit au premier moyen de régulation de courant (44) comme valeur de consigne la valeur actuelle du courant à travers ledit premier élément de contrôle de courant (20).

2. Dispositif selon la revendication 1, **caractérisé en ce que**, dans le premier mode opératoire, un système supérieur peut fournir audit ajusteur de consigne (37) une valeur de référence pour régler le voltage à travers la charge ou le courant à travers la charge sur ladite valeur de référence.

3. Dispositif selon les revendications 1 ou 2, **caractérisé en ce que**, dans un troisième mode opératoire, ledit ajusteur de consigne (37) peut être fourni avec une valeur de référence pour limiter à une valeur maximale le courant qui peut être fourni à la charge, si la somme des courants s'écoulant à travers lesdits éléments de contrôle de courant (18, 20) dépasse une valeur de seuil prédéfinissable.

4. Dispositif selon l'une quelconque des revendications 1 à 3, **caractérisé en ce que**, dans le deuxième mode opératoire, ladite unité de commande (56) prédéfinit la valeur actuelle du pus grand courant s'écoulant à travers un des éléments de contrôle de courant (18, 20) comme valeur de consigne pour le moyen de régulation de courant (44, 46) de l'autre élément de contrôle de courant (18, 20).

5. Dispositif selon l'une quelconque des revendications 2 à 4, **caractérisé en ce que** ladite unité de commande (56) change du deuxième mode opératoire au premier mode opératoire si le voltage à travers la charge ou le courant à travers la charge est encore une fois inférieure à la valeur de référence fournie par ledit système supérieur.
